# EUROPÄISCHE PATENTSCHRIFT

(11) **EP 0 536 107 B1**
(45) Veröffentlichungstag und Bekanntmachung des Hinweises auf die Patenterteilung: **11.06.1997**
(21) Anmeldenummer: 92890204.8
(22) Anmeldetag: 25.09.1992
(51) Int. Cl.: B23B 35/00, H05K 3/00

(54) **Verfahren zum Herstellen einer Bohrunterlage**
Manufacturing process of a drilling base
Procédé pour la fabrication d'un support envers de perçage

(30) Priorität: 30.09.1991 AT 1955/91
(43) Veröffentlichungstag der Anmeldung: 07.04.1993
(73) Patentinhaber: ISOVOLTA Österreichische Isolierstoffwerke Aktiengesellschaft, 2355 Wiener Neudorf (AT)
(72) Erfinder: Eichberger, Walter, A-2380 Perchtoldsdorf (AT)

(56) Entgegenhaltungen:
- DE-C- 3 229 422
- US-A- 3 700 341

## Beschreibung

Die Erfindung betrifft ein Verfahren zur Herstellung einer Bohrunterlage aus einem plattenförmigen, durch Komprimierung von gegebenenfalls mit Kunstharzen beleimten Holzfasern hergestellten Kern, der an beiden Seiten mit duromere Kunstharze enthaltenden, faserförmigen Trägermaterialien durch Heißverpressen beschichtet wird, wobei durch das Heißverpressen die duromeren Kunstharze in den faserförmigen Trägermaterialien ausgehärtet werden, sowie die Verwendung der ausschließlich nach diesem Verfahren hergestellten Bohrunterlage.

Bohrunterlagen werden beispielsweise bei der Herstellung von gedruckten Schaltungen eingesetzt, die für das Anbringen der Leiterelemente gebohrt werden müssen, wobei die elektrische Leiterplatte selbst nicht verunreinigt werden darf.

Eine Bohrunterlage der eingangs erwähnten Art ist zum Beispiel aus der US-PS-3,700,341 bekannt. Sie besteht aus einer Preßholzfaserplatte, die an beiden Seiten mit Metallfolien kaschiert ist, wobei als klebende Zwischenschicht zwischen Kern und Folie ein duromeres Kunstharz eingesetzt wird. Diese klebende Zwischenschicht kann auch in Form einer mit duromeren Kunstharzen imprägnierten, dünnen Papierschicht ausgebildet sein.
Es hat sich jedoch in der Praxis gezeigt, daß insbesondere Aluminiumfolien beim Bohrvorgang schmieren und beim Fräsen schwer zu handhaben sind.

Ferner ist aus der DE-C1 32 29 422 die Verwendung einer beidseitig glattwandig kaschierten, hochverdichteten Preßholzplatte, deren Kaschierung aus einem mit Melaminharz getränkten Vlies oder dergleichen besteht, als Bohrunterlage zum Bohren von gedruckten Schaltungen, und ein Verfahren zu deren Herstellung der eingangs erwähnten Art vorbekannt.

Dabei wird der hoch verdichtete plattenförmige Preßholzkern nach dem Nass - oder Halbtrocken verfahren hergestellt, wobei in Wasser aufgeschlämmte Holzfasern zu einem Filz vorgepreßt werden, welcher anschließend mit dem Bindemittel beleimt wird. Danach wird unter hoher Temperatur und hohem Druck das restliche Wasser abgepreßt.

Dieses Verfahren ist daher hinsichtlich der anfallenden Energiekosten, die durch die Entfernung des restlichen Wassers entstehen, relativ aufwendig.

Hier will die Erfindung Abhilfe schaffen. Die Erfindung, wie sie in den Ansprüchen gekennzeichnet ist, löst die Aufgabe, ein Verfahren der eingangs genannten Art dahingehend zu verbessern, daß durch ein energiesparendes Verfahren mit geringem apparativen Aufwand eine Bohrunterlage, die den Anforderungen der Praxis, beispielsweise beim Bohren von gedruckten Schaltungen entspricht, hergestellt werden kann.

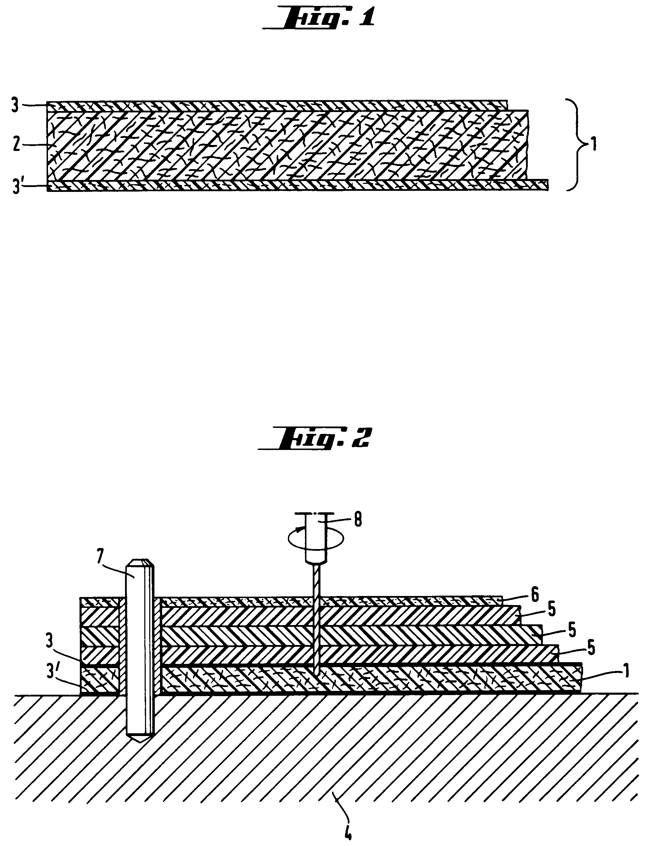

Die Erfindung wird anhand eines Ausführungsbeispiels und der Figuren 1 und 2 näher erläutert.

Fig. 1 zeigt den Querschnitt der durch das erfindungsgemäße Verfahren hergestellten Bohrunterlage.

Fig. 2 zeigt eine vorteilhafte Verwendung der Bohrunterlage beim Bohren von gedruckten Schaltungen.

### Ein bevorzugter Weg zur Ausführung der Erfindung

Es wird eine Papierbahn mit einer 60 Gew.%-igen Phenolharzlösung bis zu einem Harzauftrag von 73% imprägniert. Das imprägnierte Trägermaterial wird getrocknet und anschließend auf einen plattenförmigen Kern in Form einer nach dem Trockenverfahren hergestellten, mitteldichten (MDF) Holzfaserplatte aufgebracht.

Nach dem Trockenverfahren hergestellte MDF-Holzfaserplatten enthalten Holzfasern, welche vor der Komprimierung getrocknet worden sind, sodaß während der Komprimierung kein Wasser vorliegt und die aufgewendeten Temperaturen niedriger als beim bekannten Naßverfahren sind.

Anschließend wird der Verbund aus MDF-Holzfaserplatte und imprägnierten Trägermaterialien bei Temperaturen von 150°C bis 160°C und Drücken von 60 bis 80 bar verpreßt, wobei das Harz im Trägermaterial vollkommen aushärtet.

Der Aufbau der durch das erfindungsgemäße Verfahren hergestellten Bohrunterlage 1 ist in Fig. 1 wiedergegeben, wobei der plattenförmige Kern mit 2 bezeichnet und die beidseitigen Beschichtungen mit 3,3' bezeichnet sind.

Eine vorteilhafte Verwendung der Bohrunterlage 1 ist in Fig. 2 dargestellt. Dabei wird die Bohrunterlage 1 auf einer Arbeitsplatte 4 aufgelegt. Auf der Bohrunterlage werden nun beispielsweise drei Leiterplatten 5 aufgelegt, die mit einer Phenolhartpapierlage 6 abgedeckt sind. Dieser Aufbau wird mit einem Zentrierstift 7 an der Arbeitsplatte 4 befestigt, um beim Bohren mit der Bohrvorrichtung 8 ein Verrutschen zu verhindern. Abweichend von der vorstehenden Ausführung können anstatt Phenolharz oder eine Kunstharzmischung mit Phenolharz als wesentlichen Bestandteil auch andere duromere Kunstharze wie Melaminharze, Epoxidharze oder Harnstoffharze und Kunstharzmischungen aus solchen Harzen verwendet werden.

## Patentansprüche

1. Verfahren zur Herstellung einer Bohrunterlage aus einem plattenförmigen, durch Komprimierung von gegebenenfalls mit Kunstharzen beleimten Holzfasern hergestellten Kern, der an beiden Seiten mit duromere Kunstharze enthaltenden, faserförmigen Trägermaterialien durch Heißverpressen beschichtet wird, wobei durch das Heißverpressen die duromeren Kunstharze in den faserförmigen Trägermaterialien ausgehärtet werden, dadurch gekennzeichnet, daß als plattenförmiger Kern eine nach dem Trockenverfahren hergestellte mitteldichte (MDF) Holzfaserplatte eingesetzt wird und daß das Heißverpressen dieser MDF-Platte mit den duromere Kunstharze enthaltenden, faserförmigen Trägermaterialien bei Drücken von 60 - 80 bar erfolgt.

2. Verfahren nach Anspruch 1, dadurch gekennzeichnet, daß als faserförmiges Trägermaterial Papier eingesetzt wird.

3. Verfahren nach Anspruch 1 oder 2, dadurch gekennzeichnet, daß das zum Imprägnieren der faserförmigen Trägermaterialien eingesetzte duromere Kunstharz aus Kunstharzen oder Kunstharzgemischen besteht, die Phenolharze und/oder Melaminharze und/oder Epoxid und/oder Harnstoffharze enthalten.

4. Verfahren nach einem der Ansprüche 1 bis 3, dadurch gekennzeichnet, daß der eingesetzte plattenförmige Kern einen Harzanteil von maximal 20 Gew.% aufweist.

5. Verwendung einer Bohrunterlage ausschließlich hergestellt nach einem Verfahren gemäß einem der Ansprüche 1 bis 4 zum Bohren von gedruckten Schaltungen, dadurch gekennzeichnet, daß die Beschichtung eine Dicke von 0,03 bis 0,15 mm aufweist.

## Claims

1. A method for producing a drilling support comprising a laminar core which is produced by compressing wood fibres, optionally glued with synthetic resins, and which on both sides is coated by hot press-moulding with fibrous support materials containing thermosetting synthetic resins, wherein the thermosetting synthetic resins are cured in the fibrous support materials by the hot press-moulding, characterised in that a medium-density (MDF) wood-fibre board, produced in accordance with the dry process, is used as the laminar core, and in that the hot pressing of this MDF board is carried out with fibrous support materials containing the thermosetting synthetic resins at pressures of 60 to 80 bar.

2. A method according to Claim 1, characterised in that paper is used as the fibrous support material.

3. A method according to Claim 1 or 2, characterised in that the thermosetting synthetic resin used to impregnate the fibrous support materials consists of synthetic resins or mixtures of synthetic resins which contain phenol resins and/or melamine resins arid/or epoxide and/or urea resins.

4. A method according to any one of Claims 1 to 3, characterised in that the laminar core used has a maximum resin content of 20% by weight.

5. Use of a drilling support produced exclusively in accordance with a method according to any one of Claims 1 to 4 for drilling printed circuits, characterised in that the coating has a thickness of 0.03 to 0.15 mm.

## Revendications

1. Procédé de fabrication d'un support de perçage constitué par un coeur en forme de panneau, fabriqué par compression de fibres de bois collées, le cas échéant, avec des résines synthétiques, lequel coeur est revêtu, par compression à chaud, sur ses deux faces par des substrats fibreux contenant des résines synthétiques thermodurcissables qui sont durcies dans les substrats fibreux au cours du processus de compression à chaud, caractérisé en ce que le coeur en forme de panneau utilisé est un panneau de fibres de bois à moyenne densité (MDF), fabriqué selon le procédé sec, et en ce que la compression à chaud de ce panneau en fibres de bois à moyenne densité avec les substrats fibreux contenant des résines synthétiques thermodurcissables est réalisée à des pressions comprises entre 60 et 80 bars.

2. Procédé selon la revendication 1, caractérisé en ce que l'on utilise comme substrat fibreux du papier.

3. Procédé selon la revendication 1 ou 2, caractérisé en ce que la résine synthétique thermodurcissable utilisée pour l'imprégnation des substrats fibreux est constituée par des résines synthétiques ou des mélanges de résines synthétiques, qui contiennent des résines phénoliques et/ou des résines mélamine et/ou des résines époxides et/ou des résines d'urée.

4. Procédé selon l'une des revendications 1 à 3, caractérisé en ce que le coeur en forme de panneau utilisé présente une teneur en résine de 20 % en poids au maximum.

5. Utilisation d'un support de perçage exclusivement fabriqué selon un procédé conforme à l'une des revendications 1 à 4, pour le perçage de plaquettes de circuit imprimé, caractérisé en ce que le revêtement présente une épaisseur de 0,03 à 0,15 mm.
